(19) Europäisches Patentamt
European Patent Office
Office européen des brevets

(11) **EP 3 226 138 B1**

(12) **EUROPEAN PATENT SPECIFICATION**

(45) Date of publication and mention
of the grant of the patent:
**21.08.2019 Bulletin 2019/34**

(21) Application number: **16863197.6**

(22) Date of filing: **08.07.2016**

(51) Int Cl.:
*G06F 11/22* (2006.01)   *G01R 29/26* (2006.01)
*G01R 31/26* (2014.01)   *G01R 31/28* (2006.01)
*G06K 9/00* (2006.01)   *H04B 1/38* (2015.01)

(86) International application number:
**PCT/CN2016/089414**

(87) International publication number:
**WO 2017/133185 (10.08.2017 Gazette 2017/32)**

(54) **DATA ACQUISITION CHIP TEST SYSTEM AND DEVICE AND CONTROL METHOD THEREFOR**

DATENERFASSUNGSCHIPTESTSYSTEM UND -VORRICHTUNG SOWIE STEUERUNGSVERFAHREN DAFÜR

SYSTÈME ET DISPOSITIF DE TEST DE PUCE D'ACQUISITION DE DONNÉES ET PROCÉDÉ DE COMMANDE POUR CEUX-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.02.2016 CN 201610074545**

(43) Date of publication of application:
**04.10.2017 Bulletin 2017/40**

(73) Proprietor: **Shenzhen Goodix Technology Co., Ltd. Futian Free Trade Zone Shenzhen, Guangdong 518000 (CN)**

(72) Inventors:
• **QIN, Weihe**
**Shenzhen**
**Guangdong 518000 (CN)**

• **GUAN, Zhou**
**Shenzhen**
**Guangdong 518000 (CN)**
• **SONG, Haihong**
**Shenzhen**
**Guangdong 518000 (CN)**
• **YANG, Lian**
**Shenzhen**
**Guangdong 518000 (CN)**

(74) Representative: **Herrero & Asociados, S.L. Cedaceros, 1 28014 Madrid (ES)**

(56) References cited:
**EP-A1- 1 858 028     CN-A- 101 604 273**
**CN-A- 102 540 060   CN-A- 103 472 386**
**US-A1- 2014 098 048   US-A1- 2014 354 590**
**US-A1- 2015 253 926   US-B1- 7 969 168**

## Description

## TECHNICAL FIELD

The present invention relates to the field of fingerprint identification technologies, and in particular, test system, device for a data collecting chip and control method of the test device for the data collecting chip.

## BACKGROUND

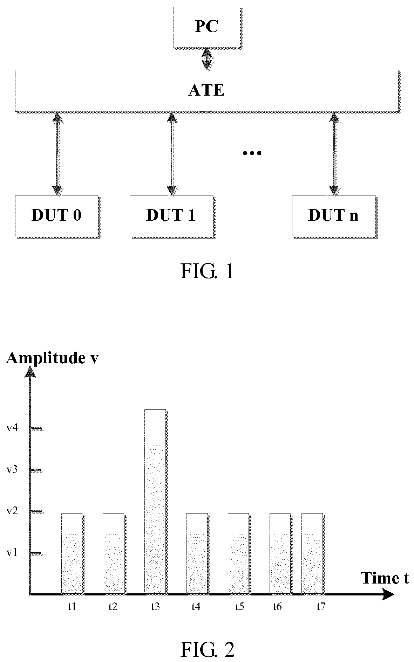

In the related technologies, as shown in FIG. 1, a test system for a fingerprint identification chip generally test a plurality of chips simultaneously, thereby improving the efficiency of the test. Since an ATE (Automatic Test Equipment, automatic test equipment) does not possess a calculation function, in the test, the ATE firstly collects test data of multiple pieces of DUTs (Device Under Test, device under test), and then uploads the test data of the multiple pieces of DUTs to a PC end to complete a noise calculation at the PC end for each piece of DUT. The noise calculation is generally to calculate a variance of position data of the same pixel in data of multiple frames.

However, in the foregoing system, since a data transmission mode between the ATE and the PC is a serial transmission, the data transmission takes a great deal of time once the amount of the data collected is large, and the test cost are increased greatly especially when a mass production test of the chip is carried out; merely using a mode of calculating the variance for the noise calculation, as shown in FIG. 2, the variance of the data does not reflect the noise level of the pixel point accurately once the noise appears as Jit, thereby affecting the stability of the fingerprint identification chip so as to reduce the accuracy of the fingerprint identification.

US2015/253926A1 relates to a semiconductor device having a touch panel controller, and specifically discloses that "the touch panel controller has detection circuits (12_1 to 12_m); electrodes (RX1_1 to RXm_n) used for capturing the signals are divided into groups in units of more than one of the electrodes; the touch panel controller performs a touch detection scan and a noise detection scan; in the noise detection scan, each detection circuit accepts input of signals from the electrodes all selected in the corresponding group to produce detection data".

US2014/098048A1 discloses adjusting a frame rate of a display panel of a touch screen according to whether noise is introduced, and specifically discloses when the touch panel is not affected by noise, driving the touch screen with a default frame rate; and when the touch panel is affected by noise, changing a frame rate of the display panel to enhance a performance of a touch screen.

US2014/354590A1 discloses finding out a frequency with minimum noise for use as a frequency of the touch driving signal when the noise interference exists. Specifically, in a first frame time interval, the touch display control system drives the in-cell touch display panel and samples the sensing voltage from the in-cell touch display panel to determine whether there is an approaching external object and noise interference. In a second frame time interval, the touch display control system finds out a frequency with minimum noise for use as a frequency of the touch driving signal when the noise interference exists. In a third frame time interval, the touch display control system is based on the frequency with minimum noise to correspondingly generate the touch driving signal so as to determine whether there is an approaching external object.

CN101604273A relates to a method and a device for automatically testing fingerprint identification systems, and discloses that according to the data type, the interface and the physical channel of the data transmission of the measured object, the automatically testing of the fingerprinting system is realized.

CN102540060A provides a test pattern-based testing system for realizing a functional test on a digital integrated circuit, and discloses that the functional test is mainly used for testing logical functions of a chip under a certain timing sequence, and the basic principle of the functional test is that the chip is activated by means of test patterns and whether the response of the chip is consistent with expected response is observed.

## SUMMARY

The present invention is designed to solve one of technical problems in the related technologies to a certain extent.

With respect to this, an objective of the present invention is to provide a test device for a data collecting chip, the device may improve the efficiency of a chip test and reduce the cost of the chip test. The test device being defined in the independent claim 1. Additional features are defined in the dependent claims 2 to 5.

Another objective of the present invention is to provide a test system for a data collecting chip. The system being defined in claim 6.

A Further objective of the present invention is to provide a control method of a test device for a data collecting chip. The control method being defined in the independent claim 7. Additional features are defined in the dependent claim 8.

To implement the foregoing objectives, one aspect of embodiments of the present invention provides a test device for a data collecting chip, the data collecting chip includes a plurality of data sampling points, and the test device includes: a data collecting module, the data collecting module being connected to the data collecting chip, and configured to receive multiple frames of sampling data collected by the data collecting chip; a storing module, the storing module being configured to store the multiple frames of sampling data; a processing module, the processing module being configured to calculate noise of the plurality of data sampling points according to the multiple frames of sampling data to obtain a noise test result; a data transceiving module, the data transceiving module being configured to upload the noise test result to an upper computer; and a control module, the control module being configured to control the data collecting module, the storing module, the processing module and the data transceiving module,

where each frame sampling data in the multiple frames of sampling data includes sampling values of the plurality of data sampling points, and the processing module includes: a calculating unit module, the calculating unit module being connected to the control module to calculate a variance of a plurality of sampling values for each data sampling point in the multiple frames of sampling data and a bulge value of the plurality of sampling values for each data sampling point in the multiple frames of sampling data; a noise determining module, the noise determining module being connected to the calculating unit module, and configured to determine whether the variance corresponding to each data sampling point is less than a predetermined variance and whether the bulge value corresponding to the each data sampling point is less than a predetermined bulge value to determine whether a noise test of the each data sampling point passes, and then obtain the noise test result.

A test device for a data collecting chip of embodiments of the present invention calculates noise of a plurality of data sampling points according to multiple frames of sampling data to obtain a noise test result by calculating the noise of the plurality of data sampling points, and upload the noise test result to an upper computer, so that the efficiency of a chip test is improved, the cost of the chip test is reduced, and the test reliability is ensured better,

In addition, according to the embodiments of the present invention, the test device for the data collecting chip may further include the following additional technical features:

Optionally, in an embodiment of the present invention, the data collecting chip is a fingerprint identification chip.

Further, in an embodiment of the present invention, the storing module includes: a memory module, configured to store the multiple frames of sampling data; a memory control module, the memory control module being connected to the memory module and the control module respectively, to control the memory module to read or write the multiple frames of sampling data under the control of the control module.

Further, in an embodiment of the present invention, the data collecting module has a cache for caching the multiple frames of sampling data.

Optionally, in an embodiment of the present invention, the test device further includes a switch module, the switch module includes one or more switches, the number of the data collecting chip is one or more, and the one or more data collecting chips are connected to the one or more switches one to one; the data collecting module receives the multiple frames of sampling data collected by the data collecting chip after the switch module is closed.

To implement the foregoing objectives, another aspect of embodiments of the present invention provides a test system for a data collecting chip, including: the test device according to the foregoing description; an automatic test equipment ATE, the ATE being connected to the test device; and a PC, the PC being connected to the ATE, the PC obtaining a noise test result uploaded by the test device via the ATE, and then performing corresponding operations on the data collecting chip according to the noise test result.

A test system for a data collecting chip of embodiments of the present invention, the test device calculates noise of a plurality of data sampling points according to multiple frames of sampling data to obtain a noise test result by calculating the noise of the plurality of data sampling points, and then determine whether the data collecting chip is qualified, and upload the noise test result to an upper computer, so that the efficiency of a chip test is improved, the cost of the chip test is reduced, and the test reliability is ensured better.

To implement the foregoing objectives, still another aspect of embodiments of the present invention provides a control method of a test device for a data collecting chip, including the following steps: receiving multiple frames of sampling data collected by the data collecting chip, and storing the multiple frames of sampling data; calculating noise of a plurality of data sampling points according to the multiple frames of sampling data to obtain a noise test result; and uploading the noise test result to an upper computer,

where each frame sampling data in the multiple frames of sampling data includes sampling values of the plurality of data sampling points, and the calculating the noise of the plurality of data sampling points according to the multiple frames of sampling data to obtain the noise test result further includes: calculating a variance of a plurality of sampling values for each data sampling point in the multiple frames of sampling data and a bulge value of the plurality of sampling values for each data sampling point in the multiple frames of sampling data; determining whether the variance corresponding to each data sampling point is less than a predetermined variance and whether the bulge value corresponding to the each data sampling point is less than a predetermined bulge value to determine whether a noise test of the each data sampling point passes, and then obtain the noise test result.

A control method of a test device for a a data collecting chip of embodiments of the present invention calculates noise of a plurality of data sampling points according to multiple frames of sampling data to obtain a noise test result by calculating the noise of the plurality of data sampling points, and upload the noise test result to an upper computer, so that the efficiency of a chip test is improved, the cost of the chip test is reduced, and the test reliability is ensured better.

In addition, according to the embodiments of the present invention, the control method may further include the additional technical features referred in the next paragraph.

Further, in an embodiment of the present invention, after the receiving the multiple frames of sampling data collected by the data collecting chip, the foregoing method further includes: caching the multiple frames of sampling data.

Additional aspects and advantages of the present invention will be partly provided in the following description, and part of them will be obvious from the following description, or may be understood by practice of the present invention.

**BRIEF DESCRIPTION OF DRAWINGS**

The foregoing and/or additional aspects and advantages of the present invention will be clear and better understood from the following description of embodiments by combining with drawings, in which:

FIG. 1 is schematic diagram of a structure of a test system for a chip of fingerprint identification type in a related technology;
FIG. 2 is a schematic diagram of Jit noise in a related technology;
FIG. 3 is a schematic diagram of a pixel matrix in a fingerprint identification chip in a related technology;
FIG. 4 is a schematic diagram of noise of a pixel point in a related technology;
FIG. 5 is a schematic diagram of a structure of a test device for a data collecting chip according to embodiments of the present invention;
FIG. 6 is a schematic diagram of a structure of a test device for a data collecting chip according to a specific embodiment of the present invention;
FIG. 7 is a flowchart diagram of a control method of a test device for a data collecting chip according to embodiments of the present invention; and
FIG. 8 is a flowchart diagram of a control method of a test device for a data collecting chip according to a specific embodiment of the present invention.

**DESCRIPTION OF EMBODIMENTS**

Embodiments of the present invention are described as follows in detail, and examples of the embodiments are illustrated in drawings, in which the same or similar labels are throughout indicative of the same or similar elements or elements with the same or similar functions. The embodiments described below with reference to the drawings are exemplary, are designed to explain the present invention, and are not understood as a limit on the present invention.

Prior to describing a test system, device for a data collecting chip and control method of the test device provided according to embodiments of the present invention, firstly, the importance of a chip test is briefly described as follows.

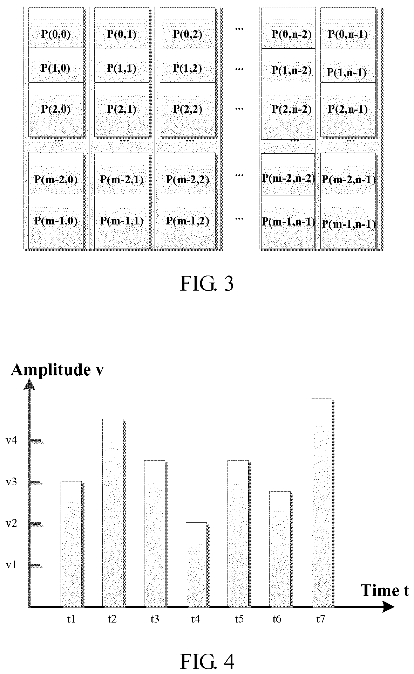

A fingerprint identification chip, for example, the stability of the fingerprint identification chip may affect the quality of a collected fingerprint image and the final accuracy of fingerprint identification. As shown in FIG. 3, $m * n$ pixel points are on the surface of the fingerprint identification chip, and each pixel point has different noise due to differences of components in a circuit and the effect of system design; as shown in FIG. 4, the drawing shows data collected at the same pixel point at different moments in no-load state, and being affected by the noise, the amplitude of the collected data may fluctuate, the greater the noise the greater the fluctuation; the data collected at the pixel point would not be identified once the noise exceeds a certain range, and the fingerprint identification would fail when the number of pixel points that cannot be identified exceeds a certain number in a $m \times n$ pixel matrix. The importance of the chip test can be known.

However, in the related technologies, a data transmission (serial transmission) between an ATE and a PC takes a great deal of time once the amount of data collected is large, the test cost is increased greatly, and since a variance of the data does not reflect the noise level of the pixel point accurately, the stability of the fingerprint identification chip is affected, and then the accuracy of fingerprint identification is reduced.

The present invention provides a test system, device for a data collecting chip and control method of the test device based on the foregoing problems.

The following describes the test system, device for a data collecting chip and control method of the test device provided according to embodiments of the present invention are described with reference to drawings. At first, the test device provided according to the embodiments of the present invention is described with reference to the drawings as follows.

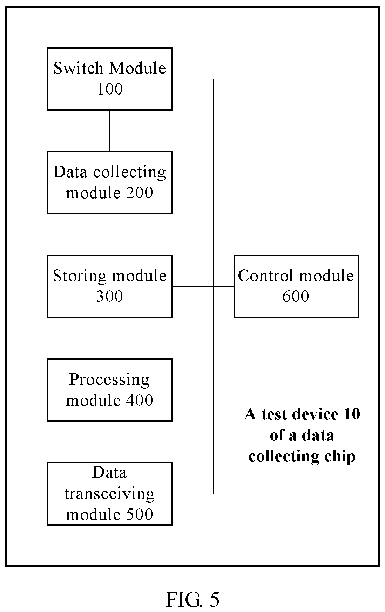

FIG. 5 is a schematic diagram of a structure of the test device for the data collecting chip according to the embodiments of the present invention.

As shown in FIG. 5, the test device 10 for the data collecting chip includes:
a switch module 100, a data collecting module 200, a storing module 300, a processing module 400, a data transceiving module 500 and a control module 600.

The data collecting chip includes a plurality of data sampling points. Particularly, the data collecting module 200 is connected to the data collecting chip via the switch module 100, so that the data collecting module 200 receives multiple frames of sampling data collected by the data collecting chip after the switch module 100 is closed. The storing module 300 is configured to store the multiple frames of sampling data. The processing module 400 is configured to calculate noise of the plurality of data sampling points according to the multiple frames of sampling data to obtain a noise test result. The data transceiving module 500 is configured to upload the noise test result to an upper computer. The control module 600 is configured to control the switch module 100, the data collecting module 200, the storing module 300, the processing module 400 and the data transceiving module 500. The test device 10 of the embodiments of the present invention has a noise calculation capability of a PC, and merely uploads the noise test result to the upper computer according to the calculation of the sampling data, and thus the amount of data transmission between the data collecting chip and the upper computer is reduced, such that the efficiency and accuracy of a chip test are improved, the cost of the chip test is reduced, and the test reliability is ensured better.

Optionally, in an embodiment of the present invention, the data collecting chip may be a fingerprint identification chip, so that the test cost of the fingerprint identification chip is reduced greatly, the stability of the fingerprint identification chip is ensured, and then the accuracy of fingerprint identification is improved.

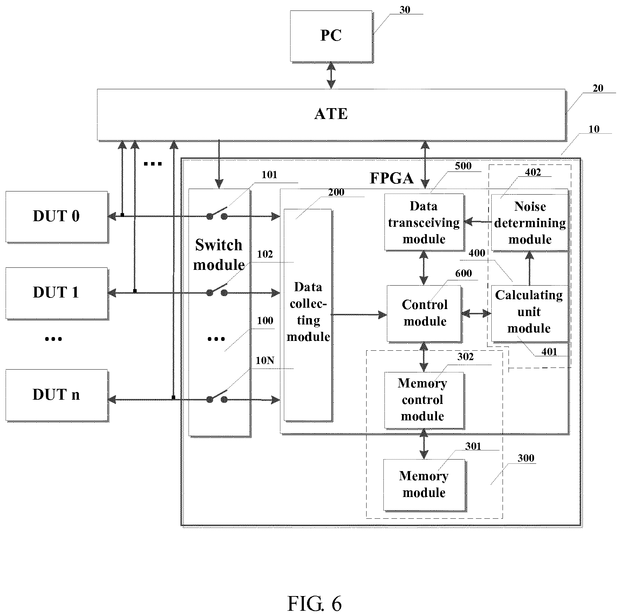

Further, in an embodiment of the present invention, as shown in FIG. 6, the upper computer of the embodiment of the present invention includes: an ATE 20 and a PC 30. The ATE 20 is connected to the test device, and the PC 30 is connected to the ATE 20.

The data collecting chip (i.e., the chip under test ), the ATE and the test device 10 of the embodiments of the present invention may communicate with each other independently; however, the chip under test and the device of the present invention are separated by the switch module 100 (equivalent to an analog switch), thereby avoiding the influence of test device 10 of the embodiments of the present invention when the ATE tests other test items of a DUT; the test device 10 of the embodiments of the present invention collects, converts and stores the data in a local mass memory to ensure the stability of the test after the switch module is closed.

Further, in an embodiment of the present invention, as shown in FIG. 6, the storing module 300 includes: a memory module 301 and a memory control module 302.

The memory module 301 is configured to store the multiple frames of sampling data. The memory control module 302 is connected to the memory module 301 and the control module 600 respectively, to control the memory module 301 to read or write the multiple frames of sampling data under the control of the control module 600.

Further, in an embodiment of the present invention, the data collecting module 200 has a cache (not specifically identified in the drawing) for caching the multiple frames of sampling data.

Optionally, in an embodiment of the present invention, as shown in FIG. 6, the switch module 100 includes one or more switches (switch 101, switch 102 ... switch ION as shown in FIG. 6), the number of the data collecting chip is one or more (DUT 0, DUT 1 ... DUT n), and the one or more data collecting chips are connected to the one or more switches one to one.

Further, in an embodiment of the present invention, as shown in FIG. 6, the processing module 400 includes: a calculating unit module 401 and a noise determining module 402.

Each frame sampling data in the multiple frames of sampling data includes sampling values of the plurality of data sampling points. Particularly, the calculating unit module 401 is connected to the control module 600 to calculate a variance of a plurality of sampling values for each data sampling point in the multiple frames of sampling data and a bulge value of the plurality of sampling values for each data sampling point in the multiple frames of sampling data. The noise determining module 402 is connected to the calculating unit module 401, and the noise determining module 402 is configured to determine whether the variance corresponding to each data sampling point is less than a predetermined variance and whether the bulge value corresponding to the each data sampling point is less than a predetermined bulge value to determine whether a noise test of the each data sampling point passes, and then obtain the noise test result of the data collecting chip. For example, the number of the data sampling points whose variance is greater than the predetermined variance, or whose bulge value is greater than the predetermined bulge value, or whose variance is greater than the predetermined variance and whose bulge value is greater than the predetermined bulge value is recorded; if the number is greater than a predetermined number, the noise test of the corresponding data collecting chip passes, otherwise it does not pass.

It is to be noted that the predetermined variance, the predetermined bulge value and the predetermined number may be adjusted according to actual conditions.

In the embodiments of the present invention, the test device 10 of the embodiments of the present invention performs the noise test by calculating the variance and the bulge value of the sampling values of the same pixel point at different moments, and the noise test result, for example, the noise test of the data collecting chip passes or does not pass, is uploaded to the upper computer, such as the ATE 20.

In a specific embodiment of the present invention, as shown in FIG. 6, the data collecting module 200, the storing module 300, the processing module 400, the data transceiving module 500 and the control module 600 may be implemented via FPGA (Field-Programmable Gate Array). The switch module 100 is responsible for controlling whether a data transmission bus between the DUT and the FPGA is conducting, and the DUT may communicate with the ATE 20 when the switch module 100 is open; the DUT communicates with the FPGA when the switch module 100 is closed. The data collecting module 200 is primarily responsible for collecting data of the DUT, that is, receiving the multiple frames of sampling data collected by the data collecting chip, then, the multiple frames of sampling data is sent to the cache after being performed a corresponding conversion, and a request signal is generated and output to a lower module when the cached data reaches a certain amount. The control module 600 is primarily responsible for controlling the whole system, such as triggering the data collecting module 200 to collect the data and receive a read cache request signal, triggering the memory control module 302 to start the memory module 301 to read or write the data, and the like. The memory control module 302 is primarily responsible for controlling the memory module 301 and arbitrating the read or write of the data. The memory module 301 is primarily responsible for storing a great deal of data of the DUT. The calculating unit module 401 is primarily responsible for completing the implementation of noise test algorithm, and outputting a result. The noise determining module 402 is primarily responsible for determining the result output by the calculating unit module 401, and determining whether the test passes. The data transceiving module 500 is primarily responsible for receiving the data sent by the ATE 20 to the FPGA and sending the noise test result to the ATE 20.

For example, the switch in the switch module 100 is closed after the ATE 20 configures the DUT and the FPGA, and the data enters the data collecting module 200 via the switch module 100; data collation is completed in the data collecting module 200, including serial-to-parallel conversion, the control module 600 is triggered after processing the cache and the like, and the control module 600 starts the memory control module 302, the memory control module 302 sequentially writing the data cached by the upper module into the memory module 301; the control module 600 starts the memory control module 302 to fetch the data from the memory module 301 to the calculating unit module 401 after storing data of N frames, the noise calculation is completed in the calculating unit module 401 and the result is sent to the noise determining module 402; a comparison according to a noise calculating result and a predetermined threshold value is implemented at the noise determining module 40 to determine whether the test of the data sampling point passes, and then the noise test result is sent to the data transceiving module 500, and sent to the PC via the ATE 20 after being analyzed; the PC classifies the DUT according to the received noise test result, for example, the noise test of the DUT 0 does not pass or pass, and the DUT whose noise test result does not pass will be discarded.

It is to be noted that how to use the variance and Jit calculation will be described in detail in the following embodiments of a control method of a test device for a data collecting chip.

According to a test device for a data collecting chip of embodiments of the present invention, after a switch module is closed, noise of a plurality of data sampling points is calculated according to multiple frames of sampling data to obtain a noise test result by calculating the noise of the plurality of data sampling points, and thus the noise test result is uploaded to an upper computer, so that the test time is reduced, and the efficiency of a chip test is improved; and a noise calculation is completed through the calulation of a variance and a bulge value, so that the accuracy of the chip test is improved, the cost of the chip test is reduced, and the test reliability is ensured better.

Embodiment of the present invention further provides a test system for a data collecting chip, and the system includes the foregoing test device, the ATE and the PC. The ATE is connected to the test device, the PC is connected to the ATE, and the PC obtains a noise test result uploaded by the test device via the ATE, and then performs corresponding operations on the data collecting chip according to the noise test result.

It is to be understood that the specific implementation procedure according to the test system of the embodiments of the present invention is the same as described in the test device of the embodiments of the present invention, and will not be described in detail herein.

According to a test system for a data collecting chip of embodiments of the present invention, a test device calculates noise of a plurality of data sampling points according to multiple frames of sampling data to determine whether the data collecting chip is qualified by calculating the noise of the plurality of data sampling points, and then upload a noise test result to a PC via an ATE, so that the test time is reduced, and the efficiency of a chip test is improved, and a noise calculation is completed through the calculation of a variance and a bulge value, so that the accuracy of the chip test is improved, the cost of the chip test is reduced, and the test reliability is ensured better.

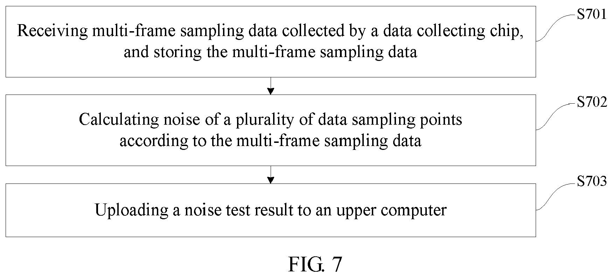

FIG. 7 is a flowchart diagram of a control method of a test device for a data collecting chip according to embodiments of the present invention.

As shown in FIG. 7, the control method of the test device for the data collecting chip (including a plurality of data sampling points) includes the following steps:

S701: receiving multiple frames of sampling data collected by the data collecting chip, and storing the multiple frames of sampling data.

In an embodiment of the present invention, after receiving the multiple frames of sampling data collected by the data collecting chip, the control method of the embodiments of the present invention further includes: caching the multiple frames of sampling data.

S702: calculating noise of the plurality of data sampling points according to the multiple frames of sampling data to obtain a noise test result.

In an embodiment of the present invention, each frame sampling data in the multiple frames of sampling data includes sampling values of the plurality of data sampling points, and the calculating the noise of the plurality of data sampling points according to the multiple frames of sampling data to obtain the noise test result further includes: calculating a variance of a plurality of sampling values for each data sampling point in the multiple frames of sampling data and a bulge value of the plurality of sampling values for each data sampling point in the multiple frames of sampling data; determining whether the variance corresponding to each data sampling point is less than a predetermined variance and whether the bulge value corresponding to the each data sampling point is less than a predetermined bulge value to determine whether a noise test of the each data sampling point passes, and then obtain the noise test result.

S703: uploading the noise test result to an upper computer.

It is to be noted that the forgoing explanation to the embodiments of the test device is further applicable to the control method of the test device of the embodiments, and the description thereof will not be described redundantly herein.

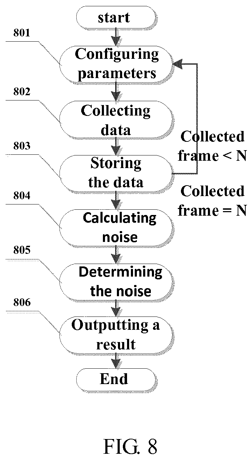

A specific embodiment of the present invention describes how to use the variance and Jit calculation in detail; as shown in FIG. 8, a control method of embodiments of the present invention includes the following steps:

S801: configuring parameters.

It is to be understood that an ATE disconnects a switch in a switch module firstly, and controls a DUT and a FPGA to operate under a specific mode by issuing configuration parameters.

The configuration of the DUT includes setting a scan mode, ADC amplitude, integration times and the like, and the DUT enters a waiting scanning state; the configuration of the FPGA includes setting pixel specification (m * n matrix), collecting data bit width, collecting data frame number of the current DUT and the like, and the FPGA finally enters a waiting collecting state.

S802: collecting data.

That is, after the ATE completes the configuration of the parameters of the DUT and the FPGA, the switch in the switch module is closed, and the DUT and the FPGA are triggered to enter a data collecting mode. A data bus connected between the DUT and the FPGA is usually a serial bus, such as SPI, $I^2C$ bus, or the like; therefore, the collected data needs to perform serial-to-parallel conversion firstly after entering the FPGA, then is stored in a cache according to a specific format, and the cache is usually implemented using FIFO. According to the parameters configured by the ATE, a request signal may be sent out when the cached data reaches a configuration number, requesting a lower module to read the data in the cache.

S803: storing the data.

Further, a memory control module is triggered when a control module receives the request signal to read the cached data in a collecting data module and write it in a memory module, where a memory is usually an external memory, such as SDRAM, SPAM or the like. Since the data collecting is to collect multiple DUTs in parallel, it is necessary to arbitrate the data in the memory control module, and the data of each DUT is written in the memory module one by one until the data of N (setting a value of N according to design requirements, N is greater than or equivalent to 2) frames are stored.

S804: calculating noise.

For example, after the data of N frames are collected, the control module triggers the memory control module to fetch the data to a calculating unit module in a specified format, and then the noise calculation for each pixel point is completed in the calculating unit module. The noise calculation includes two parts, where a first part is to calculate a variance $S^2$ of the data of the same pixel point in data of multiple frames, which can be expressed as:

$$ S^2 = \left( (x1 - M)^2 + (x2 - M)^2 \right) / n \, , $$

wherein x1, x2, ... xn correspond to data of a first, second, ... Nth frame of the pixel respectively, and M is an average value of the data of N frames of the pixel point;

A second part is to calculate a bulge value V of the data of the same pixel point in the data of multiple frames, which can be expressed as:

$$ V = \max\left( x1, x2, ..., xn \right) - \min\left( x1, x2, ..., xn \right). $$

S805: determining the noise.

The determination of the noise may be divided into two items:

One is to determine whether the variance $S^2$ and the Jit V of each pixel point are less than threshold values of a LimVar and a LimJit; if both are less than the corresponding threshold values, it is determined that a noise test on the pixel point passes; otherwise, it fails, and a counter FailNum is added by 1:

$s^2 \geq LimVar$ or $V \geq LimJit$ : fail; FailNum ++;

$s^2 < LimVar$ and $V < LimJit$ : pass;

A second is whether the number of pixels failed in the noise test in a pixel matrix is greater than a threshold value LimNum; if it is less than the threshold value LimNum, it is determined that a DUT noise test corresponding to the pixel matrix passes, otherwise it fails.

$FailNum \geq LimNum$ : fail;

$FailNum < LimNum$ : pass.

S806: outputting a result.

That is, a noise determining module sends a noise test result in a data transceiving module, and then the data transceiving module uploads the result to the ATE according to an interface protocol.

According to a control method of a test device for a data collecting chip of embodiments of the present invention, noise of a plurality of data sampling points is calculated according to multiple frames of sampling data to obtain a noise test result by calculating the noise of the plurality of data sampling points, and thus the noise test result is uploaded to an upper computer, so that the test time is reduced, and the efficiency of a chip test is improved; noise calculation is completed through the calculation of a variance and a bulge value, so that the accuracy of the chip test is improved, the cost of the chip test is reduced, and the test reliability is ensured better.

**Claims**

1. A test device (10) for a data collecting chip (DUT 0, DUT 1, DUT N), wherein the data collecting chip comprises a plurality of data sampling points, and the test device comprises:

   a data collecting module (200), the data collecting module being connected to the data collecting chip, and configured to receive multiple frames of sampling data collected by the data collecting chip;
   a storing module (300), the storing module being configured to store the multiple frames of sampling data;
   a processing module (400), the processing module being configured to calculate noise of the plurality of data sampling points according to the multiple frames of sampling data to obtain a noise test result;
   a data transceiving module (500), the data transceiving module being configured to upload the noise test result to an upper computer; and
   a control module (600), the control module being configured to control the data collecting module, the storing module, the processing module and the data transceiving module,
   wherein each frame sampling data in the multiple frames of sampling data comprises sampling values of the plurality of data sampling points, and
   the processing module comprises:

   a calculating unit module (401), the calculating unit module being connected to the control module, and configured to calculate a variance of a plurality of sampling values for each data sampling point in the multiple frames of sampling data and a bulge value of the plurality of sampling values for each data sampling point in the multiple frames of sampling data;
   a noise determining module (402), the noise determining module being connected to the calculating unit module, and configured to determine whether the variance corresponding to each data sampling point is less than a predetermined variance and whether the bulge value corresponding to the each data sampling point is less than a predetermined bulge value to determine whether a noise test of the each data sampling point passes, and then obtain the noise test result.

2. The test device according to claim 1, wherein the data collecting chip is a fingerprint identification chip.

3. The test device according to claim 1, wherein the storing module comprises:

   a memory module (301), configured to store the multiple frames of sampling data;
   a memory control module (302), the memory control module being connected to the memory module and the control module respectively, and being configured to control the memory module to read or write the multiple frames of sampling data under the control of the control module.

4. The test device according to claim 1, wherein the data collecting module has a cache for caching the multiple frames of sampling data.

5. The test device according to claim 1, wherein the test device further comprises a switch module (100), the switch module comprises one or more switches (101, 102, 10N), the number of the data collecting chip is one or more, and the one or more data collecting chips are connected to the one or more switches one to one;
   the data collecting module being configured to receive the multiple frames of sampling data collected by the data collecting chip after the switch module is closed.

6. A test system for a data collecting chip, the test system comprising:

   the test device (10) according to any one of claims 1 to 5;
   an automatic test equipment ATE (20), the ATE being connected to the test device; and
   a PC (30), the PC being connected to the ATE, the PC being configured to obtain a noise test result uploaded by the test device via the ATE, and perform corresponding operations on the data collecting chip according to the noise test result.

7. A control method of a test device for a data collecting chip, wherein the test device is according to any one of claims 1 to 5 and the data collecting chip comprises a plurality of data sampling points, the method comprising the steps of:

   receiving multiple frames of sampling data collected by the data collecting chip, and storing the multiple frames of sampling data;
   calculating noise of the plurality of data sampling points according to the multiple frames of sampling data to obtain a noise test result; and

uploading the noise test result to an upper computer,

wherein each frame sampling data in the multiple frames of sampling data comprises sampling values of the plurality of data sampling points, and the calculating the noise of the plurality of data sampling points according to the multiple frames of sampling data to obtain the noise test result further comprises:

calculating a variance of a plurality of sampling values for each data sampling point in the multiple frames of sampling data and a bulge value of the plurality of sampling values for each data sampling point in the multiple frames of sampling data;
determining whether the variance corresponding to each data sampling point is less than a predetermined variance and whether the bulge value corresponding to the each data sampling point is less than a predetermined bulge value to determine whether a noise test of the each data sampling point passes, and then obtain the noise test result.

8. The control method according to claim 7, wherein after the receiving the multiple frames of sampling data collected by the data collecting chip, the method further comprises:
caching the multiple frames of sampling data.

**Patentansprüche**

1. Prüfvorrichtung (10) für einen Datensammelchip (DUT 0, DUT 1, DUT N), wobei der Datensammelchip mehrere Datenabtastpunkte aufweist und die Prüfvorrichtung aufweist:

ein Datensammelmodul (200),
wobei das Datensammelmodul mit dem Datensammelchip verbunden und dafür konfiguriert ist, mehrere Rahmen von durch den Datensammelchip gesammelten Abtastdaten zu empfangen;
ein Speichermodul (300),
wobei das Speichermodul dafür konfiguriert ist, die mehreren Rahmen von Abtastdaten zu speichern;
ein Verarbeitungsmodul (400),
wobei das Verarbeitungsmodul dafür konfiguriert ist, Rauschen der mehreren Datenabtastpunkte gemäß den mehreren Rahmen von Abtastdaten zu berechnen, um ein Rauschprüfergebnis zu erhalten;
ein Datentransceivermodul (500),
wobei das Datentransceivermodul dafür konfiguriert ist, das Rauschprüfergebnis zu einem übergeordneten Computer hochzuladen; und
ein Steuermodul (600),
wobei das Steuermodul dafür konfiguriert ist, das Datensammelmodul, das Speichermodul, das Verarbeitungsmodul und das Datentransceivermodul zu steuern,
wobei jeder Rahmen von Abtastdaten unter den mehreren Rahmen von Abtastdaten Abtastwerte der mehreren Datenabtastpunkte aufweist, und
wobei das Verarbeitungsmodul aufweist:

ein Recheneinheitmodul (401),
wobei das Recheneinheitmodul mit dem Steuermodul verbunden und dafür konfiguriert ist, eine Varianz mehrerer Abtastwerte für jeden Datenabtastpunkt in den mehreren Rahmen von Abtastdaten und einen Bulge-Wert der mehreren Abtastwerte für jeden Datenabtastpunkt in den mehreren Rahmen von Abtastdaten zu berechnen; und
ein Rauschbestimmungsmodul (402),

wobei das Rauschbestimmungsmodul mit dem Recheneinheitmodul verbunden und dafür konfiguriert ist, zu bestimmen, ob die jedem Datenabtastpunkt entsprechende Varianz kleiner ist als eine vorgegebene Varianz, und ob der jedem Datenabtastpunkt entsprechende Bulge-Wert kleiner ist als ein vorgegebener Bulge-Wert, um zu bestimmen, ob eine Rauschprüfung für jeden Datenabtastpunkt bestanden wurde, und dann das Rauschprüfergebnis zu erhalten.

2. Prüfvorrichtung nach Anspruch 1, wobei der Datensammelchip ein Fingerabdruckidentifizierungschip ist.

3. Prüfvorrichtung nach Anspruch 1, wobei das Speichermodul aufweist:

ein Speichermodul (301), das dafür konfiguriert ist, die mehreren Rahmen von Abtastdaten zu speichern; und
ein Speichersteuermodul (302),
wobei das Speichersteuermodul mit dem Speichermodul und dem Steuermodul verbunden und dafür konfiguriert ist, das Speichermodul zu steuern, um die mehreren Rahmen von Abtastdaten unter der Steuerung des Steuermoduls zu lesen oder zu schreiben.

4. Prüfvorrichtung nach Anspruch 1, wobei das Datensammelmodul einen Cache zum Zwischenspeichern der mehreren Rahmen von Abtastdaten aufweist.

**5.** Prüfvorrichtung nach Anspruch 1, wobei die Prüfvorrichtung ferner ein Schaltermodul (100) aufweist,

> wobei das Schaltermodul einen oder mehrere Schalter (101, 102, 10N) aufweist,
> wobei die Anzahl der Datensammelchips eins oder mehr beträgt und der eine oder die mehreren Datensammelchips mit dem einen oder den mehreren Schaltern eins zu eins verbunden sind,
> wobei das Datensammelmodul dafür konfiguriert ist, die mehreren Rahmen von durch den Datensammelchip gesammelten Abtastdaten zu empfangen, nachdem das Schaltermodul geschlossen wurde.

**6.** Prüfsystem für einen Datensammelchip, wobei das Prüfsystem aufweist:

> die Prüfvorrichtung (10) nach einem der Ansprüche 1 bis 5;
> eine automatische Prüfeinrichtung ATE (20), wobei die ATE mit der Prüfvorrichtung verbunden ist; und
> einen PC (30),
> wobei der PC mit der ATE verbunden ist, und wobei der PC dafür konfiguriert ist, ein Rauschprüfergebnis, das durch die Prüfvorrichtung über die ATE hochgeladen wurde, zu erhalten und gemäß dem Rauschprüfergebnis entsprechende Operationen bezüglich des Datensammelchips auszuführen.

**7.** Steuerverfahren für eine Prüfvorrichtung für einen Datensammelchip, wobei die Prüfvorrichtung eine Prüfvorrichtung nach einem der Ansprüche 1 bis 5 ist und der Datensammelchip mehrere Datenabtastpunkte aufweist, wobei das Verfahren die Schritte aufweist:

> Empfangen mehrerer Rahmen von durch den Datensammelchip gesammelten Abtastdaten und Speichern der mehreren Rahmen von Abtastdaten;
> Berechnen von Rauschen der mehreren Datenabtastpunkte gemäß den mehreren Rahmen von Abtastdaten, um ein Rauschprüfergebnis zu erhalten; und
> Hochladen des Rauschprüfergebnisses zu einem übergeordneten Computer,
> wobei jeder Rahmen von Abtastdaten unter den mehreren Rahmen von Abtastdaten Abtastwerte der mehreren Datenabtastpunkte aufweist, und wobei das Berechnen des Rauschens der mehreren Datenabtastpunkte gemäß den mehreren Rahmen von Abtastdaten zum Erhalten des Rauschprüfergebnisses ferner aufweist:

> Berechnen einer Varianz mehrerer Abtastwerte für jeden Datenabtastpunkt in den mehreren Rahmen von Abtastdaten und eines Bulge-Werts der mehreren Abtastwerte für jeden Datenabtastpunkt in den mehreren Rahmen von Abtastdaten; und
> Bestimmen, ob die jedem Datenabtastpunkt entsprechende Varianz kleiner ist als eine vorgegebene Varianz, und ob der jedem Datenabtastpunkt entsprechende Bulge-Wert kleiner ist als ein vorgegebener Bulge-Wert, um zu bestimmen, ob eine Rauschprüfung für jeden Datenabtastpunkt bestanden wurde, und anschließendes Erhalten des Rauschprüfergebnisses.

**8.** Steuerverfahren nach Anspruch 7, wobei nach dem Empfang der mehreren Rahmen von durch den Datensammelchip gesammelten Abtastdaten das Verfahren ferner das Zwischenspeichern der mehreren Rahmen von Abtastdaten aufweist.

**Revendications**

**1.** Dispositif de test (10) pour une puce de collecte de données (DUT 0, DUT 1, DUT N), dans lequel la puce de collecte de données comprend une pluralité de points d'échantillonnage de données, et le dispositif de test comprend :

> un module de collecte de données (200), le module de collecte de données étant connecté à la puce de collecte de données, et configuré pour recevoir de multiples trames de données d'échantillonnage collectées par la puce de collecte de données ;
> un module de stockage (300), le module de stockage étant configuré pour stocker les multiples trames de données d'échantillonnage ;
> un module traitement (400), le module de traitement étant configuré pour calculer un bruit de la pluralité de points d'échantillonnage de données conformément aux multiples trames de données d'échantillonnage pour obtenir un résultat de test de bruit ;
> un module d'émission-réception de données (500), le module d'émission-réception de données étant configuré pour télécharger vers l'amont le résultat de test de bruit sur un ordinateur supérieur ; et
> un module de commande (600), le module de commande étant configuré pour commander le module de collecte de données, le module de stockage, le module de traitement et le module d'émission-réception de données,
> dans lequel chaque donnée d'échantillonnage de trame dans les multiples trames de données d'échantillonnage comprend des valeurs d'échantillonnage de la pluralité de points d'échantillonnage de données, et le module de traitement comprend :

un module d'unité de calcul (401), le module d'unité de calcul étant connecté au module de commande, et configuré pour calculer une variance d'une pluralité de valeurs d'échantillonnage pour chaque point d'échantillonnage de données dans les multiples trames de données d'échantillonnage et une valeur d'augmentation de la pluralité de valeurs d'échantillonnage pour chaque point d'échantillonnage de données dans les multiples trames de données d'échantillonnage ;
un module de détermination de bruit (402), le module de détermination de bruit étant connecté au module d'unité de calcul, et configuré pour déterminer si la variance correspondant à chaque point d'échantillonnage de données est inférieure à une variance prédéterminée et si la valeur d'augmentation correspondant à chacun de ces points d'échantillonnage de données est inférieure à une valeur d'augmentation prédéterminée pour déterminer si un test de bruit de chacun de ces points d'échantillonnage de données réussit, puis obtenir le résultat de test de bruit.

2. Dispositif de test selon la revendication 1, dans lequel la puce de collecte de données est une puce d'identification d'empreinte digitale.

3. Dispositif de test selon la revendication 1, dans lequel le module de stockage comprend :

un module de mémoire (301), configuré pour stocker les multiples trames de données d'échantillonnage ;
un module de commande de mémoire (302), le module de commande de mémoire étant connecté au module de mémoire et au module de commande respectivement, et étant configuré pour commander le module de mémoire pour lire ou écrire les multiples trames de données d'échantillonnage sous la commande du module de commande.

4. Dispositif de test selon la revendication 1, dans lequel le module de collecte de données a un cache permettant de mettre en cache les multiples trames de données d'échantillonnage.

5. Dispositif de test selon la revendication 1, dans lequel le dispositif de test comprend en outre un module à commutateurs (100), le module à commutateurs comprend un ou plusieurs commutateurs (101, 102, 10N), le nombre de la puce de collecte de données est une ou plus, et les une ou plusieurs puces de collecte de données sont connectées une à une aux un ou plusieurs commutateurs ;
le module de collecte de données étant configuré pour recevoir les multiples trames de données d'échantillonnage collectées par la puce de collecte de données après que le module à commutateurs a été fermé.

6. Système de test pour une puce de collecte de données, le système de test comprenant :

le dispositif de test (10) selon l'une quelconque des revendications 1 à 5 ;
un équipement de test automatique ATE (20), l'ATE étant connecté au dispositif de test ; et
un PC (30), le PC étant connecté à l'ATE, le PC étant configuré pour obtenir un résultat de test de bruit téléchargé vers l'amont par le dispositif de test via l'ATE, et effectuer des opérations correspondantes sur la puce de collecte de données conformément au résultat de test de bruit.

7. Procédé de commande d'un dispositif de test pour une puce de collecte de données, dans lequel le dispositif de test est selon l'une quelconque des revendications 1 à 5 et la puce de collecte de données comprend une pluralité de points d'échantillonnage de données, le procédé comprenant les étapes consistant à :

recevoir de multiples trames de données d'échantillonnage collectées par la puce de collecte de données, et stocker les multiples trames de données d'échantillonnage ;
calculer un bruit de la pluralité de points d'échantillonnage de données conformément aux multiples trames de données d'échantillonnage pour obtenir un résultat de test de bruit ; et
télécharger vers l'amont le résultat de test de bruit sur un ordinateur supérieur,
dans lequel chaque donnée d'échantillonnage de trame dans les multiples trames de données d'échantillonnage comprend des valeurs d'échantillonnage de la pluralité de points d'échantillonnage de données, et le calcul du bruit de la pluralité de points d'échantillonnage de données conformément aux multiples trames de données d'échantillonnage pour obtenir le résultat de test de bruit comprend en outre :

le calcul d'une variance d'une pluralité de valeurs d'échantillonnage pour chaque point d'échantillonnage de données dans les multiples trames de données d'échantillonnage et d'une valeur d'augmentation de la pluralité de valeurs d'échantillonnage pour chaque point d'échantillonnage de données dans les multiples trames de données d'échantillonnage ;

le fait de déterminer si la variance correspondant à chaque point d'échantillonnage de données est inférieure à une variance prédéterminée et si la valeur d'augmentation correspondant à chacun de ces points d'échantillonnage de données est inférieure à une valeur d'augmentation prédéterminée pour déterminer si un test de bruit de chacun de ces points d'échantillonnage de données réussit, puis obtenir le résultat de test de bruit.

8. Procédé de commande selon la revendication 7, dans lequel, après la réception des multiples trames de données d'échantillonnage collectées par la puce de collecte de données, le procédé comprend en outre :

la mise en cache des multiples trames de données d'échantillonnage.

FIG. 1

FIG. 2

| P(0,0) | P(0,1) | P(0,2) | ... | P(0,n-2) | P(0,n-1) |
| P(1,0) | P(1,1) | P(1,2) | ... | P(1,n-2) | P(1,n-1) |
| P(2,0) | P(2,1) | P(2,2) | ... | P(2,n-2) | P(2,n-1) |
| ... | ... | ... | | ... | ... |
| P(m-2,0) | P(m-2,1) | P(m-2,2) | ... | P(m-2,n-2) | P(m-2,n-1) |
| P(m-1,0) | P(m-1,1) | P(m-1,2) | ... | P(m-1,n-1) | P(m-1,n-1) |

FIG. 3

FIG. 4

Switch Module 100

Data collecting module 200

Storing module 300 — Control module 600

Processing module 400

Data transceiving module 500

A test device 10 of a data collecting chip

FIG. 5

FIG. 6

Receiving multi-frame sampling data collected by a data collecting chip, and storing the multi-frame sampling data ⟋ S701

Calculating noise of a plurality of data sampling points according to the multi-frame sampling data ⟋ S702

Uploading a noise test result to an upper computer ⟋ S703

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015253926 A1
- US 2014098048 A1
- US 2014354590 A1
- CN 101604273 A
- CN 102540060 A